# EUROPEAN PATENT APPLICATION

(11) **EP 4 810 972 A1**
(43) Date of publication of application: **23.09.2026**
(21) Application number: 26158773.7
(22) Date of filing: 16.02.2026
(51) Int. Cl.: G01R 31/34

(54) **SHORT-CIRCUIT DETECTION IN A BIFILAR ELECTRIC DRIVE SYSTEM**

(30) Priority: 21.03.2025 GB 202504152
(71) Applicant: Rolls-Royce Deutschland Ltd & Co KG, 15827 Blankenfelde-Mahlow (DE)
(72) Inventor: YIRISAW, Tadele, 15827 Blankenfelde-Mahlow (DE); REEH, Andreas, 15827 Blankenfelde-Mahlow (DE)

(57) **Abstract**

A method for detecting a fault in a bifilar electric machine (2, 2') comprises: operating (S1) the electric machine (2, 2') with a pulse-width modulated voltage supply using a switching frequency fsw; measuring (S2) at least one phase current of at least one phase (U, V, W) of the electric machine (2, 2') during the operation of the electric machine (2, 2'); analyzing (S3) a frequency band (FB) of the at least one phase current of the at least one phase (U, V, W) around the switching frequency fsw or around an integer multiple of the switching frequency fsw to obtain a value; and comparing (S4) the value with a threshold to detect a fault if the value exceeds the threshold.

## Description

### TECHNICAL FIELD

The present disclosure relates in particular to a method for detecting a fault in a bifilar electric machine, to a computer-readable storage medium, to an arrangement with an electric machine and to an aircraft having such an arrangement.

### BACKGROUND

The electric machine of such an arrangement includes an electrical winding system. By applying voltages to the winding system, particularly voltages that vary over time, the created currents induce magnetic fields that may cause a rotation of a rotor.

Especially in conventional multiphase rotating field machines, (e.g., having a permanently excited rotor), such as in drive systems based on permanent-magnet synchronous machines, it is problematic when a winding short circuit occurs in a coil between adjacent turns. In particular in such electric machines, the problem exists that, in the event of such a winding short circuit during intended operation, a large electrical current may be induced in the loop created by the short circuit, which may result in a thermal destruction of the windings. This is relevant not only, but particularly, in aircrafts in which, e.g., permanently excited rotating-field machines are used.

### SUMMARY AND DESCRIPTION

The object of the present disclosure is to provide a reliable fault detection in a bifilar electric machine, e.g., electric drive. The scope of the present disclosure is defined solely by the appended claims and is not affected to any degree by the statements within this summary. The present embodiments may obviate one or more of the drawbacks or limitations in the related art.

According to one aspect, a method for detecting a fault in a bifilar electric machine, e.g., in an electric drive system, is provided. The method comprises operating the electric machine with a pulse-width modulated voltage (e.g., inverter) supply having a switching frequency (fsw). The method further comprises measuring at least one phase current of at least one phase of the electric machine during the operation of the electric machine. The method further comprises analyzing a frequency band of the at least one phase current of the at least one phase around the switching frequency (fsw) and/or around an (e.g., odd) integer multiple of the switching frequency (n * fsw) to obtain a value. The method further comprises comparing the obtained value with a threshold to detect a fault if the value exceeds the threshold.

The bifilar electric machine comprises, e.g., a first winding system and a second winding system wherein at least one electrical conductor of the first winding system and at least one electrical conductor of the second winding system are at least partially wound around a common winding axis, wherein the turns of the electrical conductors of the different winding systems alternate in a direction of the winding axis. The conductors form one or more bifilar coils. The alternating adjacent arrangement of the conductor windings of the first and second winding systems can also be referred to as bifilar arrangement of the electrical conductor of the first winding system with the electrical conductor of the second winding system. The electrical conductors of the two winding systems are arranged adjacently in a bifilar manner. The alternating arrangement of the electrical conductors of the two winding systems allows to prevent, in the case of an short-circuit within a coil between two adjacent winding turns, creating a closed loop, because every connection between the adjacent turns will instead create a connection of the two winding systems that were electrically separate before. Therefore, the creation of a closed loop, in which during, e.g., further rotation of a rotor of the electric machine very large currents could be induced, is avoided. However, if the source of the two systems is galvanically the same, a fault that connects the two winding systems may still lead to a strong heating of parts of the electric machine and to a further destruction. Therefore, it is advantageous if an emerging fault is detected as early as possible, so that countermeasures can be initiated before resulting damages occur. Such countermeasures may comprise switching off one or all inverters, braking a rotor etc. In the case of an inter-turn short circuit between the bifilar systems, the three-phase symmetry which is present in a healthy state is broken. Theoretical and simulation analyses have revealed that this defect enables current flow at the switching frequency (fsw) and odd multiples of the switching frequency from one winding system to the other. Therefore, by considering the frequency band around the switching frequency, an unambiguous indicator for a winding fault can be obtained, as this harmonic mode is suppressed in healthy conditions. Thus, the proposed method provides a reliable fault detection in a bifilar electric machine.

The value may be the spectral energy within the frequency band. This allows a high sensitivity and a low false-positive rate of the detection. Alternatively or in addition, the maximum magnitude within the frequency band may be used, which is particularly simple to implement. The value may be obtained by determining the difference of the spectral energy, magnitude or other parameter of one phase with the respective parameter of another phase (or each other phase). So, it may be determined if the difference exceeds the threshold.

The frequency band may be centered at the switching frequency or at an integer multiple of the switching frequency (n * fsw). This allows to symmetrically exclude sidebands present in a normal operation of the electric machine.

Operating the electric machine may comprise comparing a carrier signal (e.g., switching signal) with a reference signal. The reference signal has a frequency referred to as fundamental frequency (fel) for ease of reference. This allows a simple but precise generation of PWM signals, e.g., when the reference signal is higher than the carrier signal.

The width of the frequency band may be equal to or smaller than six or four times the fundamental frequency (6 * fel or 4* fel), in particular equal to or smaller than two times the fundamental frequency (2 * fel). These widths allow to use large parts of the fault signal.

For example, a sine PWM with a carrier signal is a sawtooth signal, or a triangle signal. The reference signal may be a sine wave. These signal types allow a well-tuned operation of the electric machine. As another example, space-vector modulation may be used for control of the pulse-width modulation.

The frequency of the carrier signal of the inverter may be at least one order of magnitude higher than the fundamental frequency of the reference signal. This allows a well-tuned operation of the electric machine and, at the same time, a clear separation of harmonics in a healthy state and a fault signal in a faulty state.

According to an example, the threshold is defined based on an operating speed of the electric machine, e.g., of a rotational speed of a rotor of the electric machine. The separation of the normal harmonics to the eventual fault signal can depend on the speed. So, if the threshold is adapted to the speed, e.g., increased with increasing speed (or vice versa), an improved detection of faults at various speeds can be obtained. Accordingly, as an alternative or an addition, the width of the frequency band may be defined based on the operating speed of the electric machine, e.g., of a rotational speed of a rotor of the electric machine (e.g., increased with increasing speed, or vice versa).

As already discussed, the electric machine may comprise a first winding system and a second winding system, wherein at least one electrical conductor of the first winding system and at least one electrical conductor of the second winding system are at least partially wound around a common winding axis, wherein turns of the electrical conductors alternate in a direction of the winding axis. It can further be provided that measuring the at least one phase current comprises measuring a phase current of at least one phase of the first winding system and measuring a phase current of at least one phase of the second winding system during the operation of the electric machine and adding the phase currents before the analyzing of the frequency band of the added phase currents. This allows a further improvement of the precision of the detection.

According to one aspect, a computer-readable storage medium is provided, comprising instructions that, when executed by at least one processor of a control unit of a bifilar electric machine, cause the control unit to perform the described method.

According to one aspect, an arrangement, e.g., for an aircraft or other kind of vehicle, is provided. The arrangement comprises an electric machine with a first winding system and a second winding system wherein at least one electrical conductor of the first winding system and at least one electrical conductor of the second winding system are at least partially wound around a common winding axis, wherein the turns of the electrical conductors of the different winding systems alternate in a direction of the winding axis. The arrangement further comprises a first inverter for supplying the first winding system with a multi-phase current, a second inverter for supplying the second winding system with a multi-phase current and a control unit. The control unit is configured to: operate the electric machine with pulse-width modulation based on a carrier signal having a frequency fsw (e.g., based on any PWM method including, but not limited to, sinusoidal PWM, third harmonic injection PWM, space vector PWM, and related PWM techniques); measure at least one phase current of at least one phase of the bifilar electric machine during the operation of the electric machine; analyze a frequency band of the at least one phase current of the at least one phase (e.g., of the sum of the two corresponding phase currents in the three phase systems, e.g., phase U of both winding systems) around the switching frequency fsw and/or around an integer multiple of the switching frequency fsw to obtain a value; and compare the value with a threshold to detect a fault if the value exceeds the threshold.

The arrangement may be a drive system.

For example, at the switching frequency and its integer multiple harmonics in all the measured phases are compared with each other to detect a fault if the amplitude difference(s) is greater than a threshold.

The control unit may comprise a digital or analogue bandpass filter, wherein analyzing the frequency band comprises applying the bandpass filter to the measured at least one phase current. A digital bandpass filter can provide flexibility, an analogue bandpass filter can be particularly robust, reliable and need no computing power.

The first winding system may comprise multiple, e.g., three, phases connected to one another with one respective end at a common first star point and to an inverter unit of the first inverter with the respective other end. Alternatively, or in addition, the second winding system may comprise multiple, e.g., three, phases connected to one another with one respective end at a common second star point and to an inverter unit of the second inverter with the respective other end. Such an electric machine can provide a high gravimetric and volumetric torque density with a high efficiency.

Alternatively, instead of the star point connection(s), full H-bridge inverters may be used. Then, each electrical conductor is connected to one inverter unit with one end and to another inverter unit at its other end.

The electric machine may comprise a stator with the winding systems and a rotor rotatably mounted at the stator. Such an electric machine may be used as a motor and/or a generator.

According to one aspect, a vehicle, (e.g., an aircraft), is provided. The vehicle includes the arrangement (at least one such arrangement) according to any configuration described herein, in particular for driving a thrust-generating apparatus, e.g. a propeller. The advantages of the arrangement described herein apply especially to a vehicle, in particular an aircraft. However, the assembly may also be used in a gas pump, in a marine engine, in a wind turbine, in an electric car, or in a generator.

### BRIEF DESCRIPTION OF THE DRAWINGS

Embodiments will now be described by way of example with reference to the figures in which:
- FIG. 1: depicts a schematic sectional illustration of an example of a basic design of a permanently excited, three-phase electric machine having an internal rotor.
- FIG. 2: depicts a schematic, perspective exploded view of an example of a design of an arrangement comprising a stator of the electric machine according to FIG. 1 with tooth windings.
- FIG. 3: depicts a schematic illustration of an example of part of a tooth winding of the arrangement according to FIG. 2, in which turns of a first and second electrical conductor are arranged in a bifilar manner.
- FIG. 4: depicts a schematic illustration of an example of a permanently excited electric machine for operation at a three-phase AC voltage.
- FIGS. 5 and 6: depict schematic circuit diagram illustrations of examples of tooth windings and inverter units of an inverter of the electric machine according to FIG. 2 and FIG. 4, respectively.
- FIG. 7: depicts an example of a carrier signal and a reference signal to create PWM signals;
- FIG. 8: depicts an example of PWM signals for the inverter units.
- FIG. 9: depicts a block diagram of an example of components of the inverter.
- FIGs. 10 and 11: depict currents in winding systems having an insulation fault between two turns of a bifilar coil creating a connection between the two systems, in case of the galvanic coupling via the DC bus.
- FIG. 12: depicts a frequency spectrum of a phase current in a healthy condition of the electric machine supplied with a sine PWM.
- FIG. 13: depicts a frequency spectrum of a phase current in a condition of the electric machine with a low resistance short circuit between adjacent coil turns.
- FIG. 14: depicts a frequency spectrum of a phase current in a condition of the electric machine with a high resistance short circuit between adjacent coil turns.
- FIG. 15: depicts a method for detecting a fault in a bifilar electric machine.
- FIG. 16: depicts an example of an aircraft in the form of an airplane having an electrically driven propeller and the electric machine.

### DETAILED DESCRIPTION

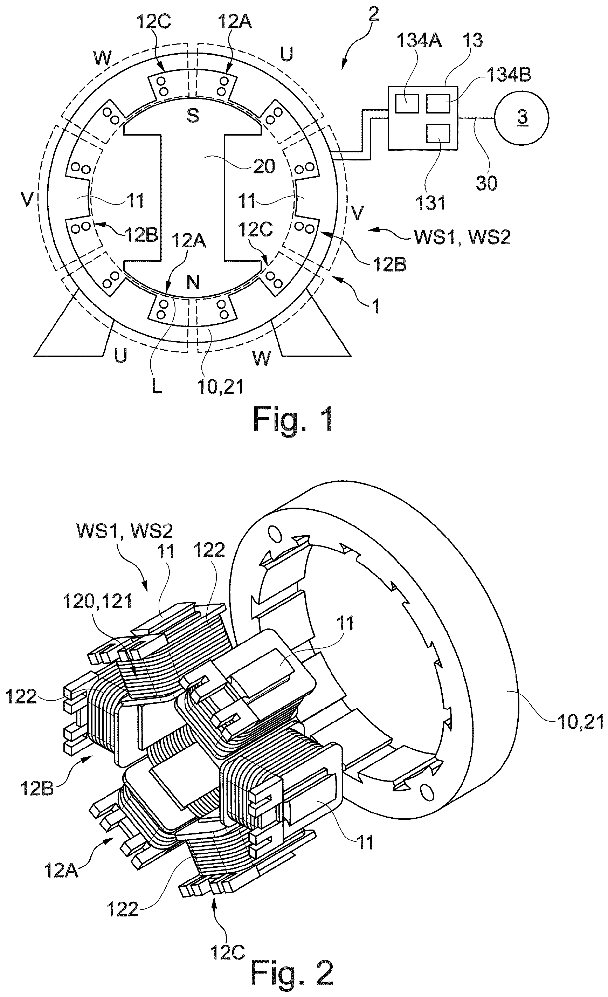

FIG. 1 shows an arrangement 1 including an electric machine 2. The electric machine 2 is shown in a schematic sectional illustration. In the present example, the electric machine 2 is a rotating electric machine 2 in the form of a permanently excited synchronous machine. In FIG. 1, the electric machine 2 is in the form of a machine with an internal rotor. The electric machine 2 comprises a stator 21 that has an opening, in particular a through-opening in which a rotor 20 is arranged in a rotatably mounted manner.

The stator 21 includes a body 10 in the form of a laminated core, on which teeth are anchored, which are referred to below as stator teeth 11. The stator teeth 11 are aligned with an air gap L between the body 10 of the stator 21 and the rotor 20. The stator teeth 11 protrude radially from the body 10, in the present case radially inward. The stator 21 has a stator winding that includes a plurality of windings 12A-12C (in the form of tooth windings). The stator winding in the present case is designed for three-phase operation, (connected to a three-phase AC voltage having phases U, V, W). During intended operation of the electric machine 2, the AC voltage is accordingly applied to the stator winding.

The rotor 20 is in the form of a salient-pole rotor that includes permanent magnets for providing the magnetic flux. In the present configuration, there is provision for the rotor 20 to have exactly one magnetic north pole N and one magnetic south pole S. In alternative configurations, there may also be provision for more magnetic poles, e.g., in alternation in the circumferential direction transverse to an axis of rotation of the rotor 20 (relative to the stator 21).

The rotor 20 is rotatably mounted. As a result of the three-phase AC voltage, the phases U, V, W thereof each being phase-shifted by 120°, a magnetic rotating field is generated during intended operation, which magnetic rotating field interacts with the permanently excited magnetic field provided by the rotor 20 such that a corresponding rotational movement of the rotor 20 in relation to the stator 21 may be brought about during operation of the motor. In certain examples, the electric machine 2 is used as a drive motor, e.g., for a propeller of an aircraft. The portions of the stator winding assigned to the respective phases U, V, W are schematically illustrated in FIG. 1. One winding 12A-12C is in each case respectively assigned to one of the phases U, V, W.

The stator winding of the electric machine 2 is connected to an inverter system 13 (in this example of a three-phase design). The inverter system 13 provides the electric AC voltage with the three phases U, V, W. The inverter system 13 obtains the electric energy required for the intended operation from an energy source 3 connected to the inverter system 13. In the present configuration, the energy source 3 is a DC voltage source which provides electrical energy from a suitable electrical energy store, for example, a rechargeable battery or the like. Alternatively, or additionally, a fuel cell and/or the like or, in the case of stationary applications, an energy supply from a public energy supply network may be provided, for which purpose a rectifier for converting an alternating current of the public energy supply network into direct current may be provided.

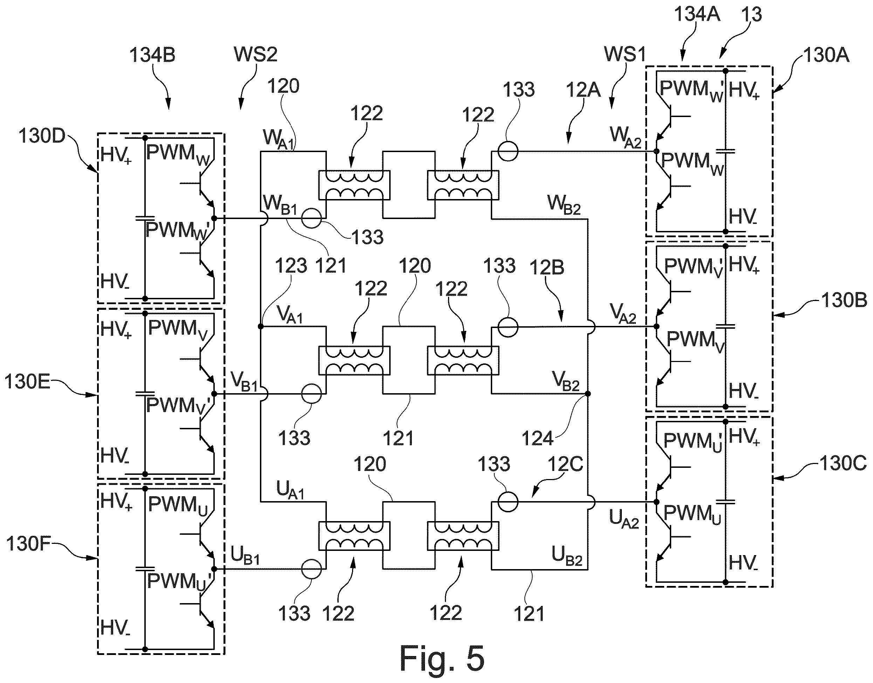

The inverter system 13 has inverter units assigned for providing the phases U, V, W, which inverter units are explained in more detail further below in connection with FIG. 5, for example. In this case, each inverter unit has its own half-bridge circuit. The half-bridge circuits are connected to a common DC bus 30 circuit for the inverter system 13, in order to thus be supplied with electrical energy. The DC bus 30 may have a voltage of 25 V or more, 100 V or more, or in the range of 800 to 3000 V. The DC bus 30 provides electrical current to all inverters 134A, 134B and their inverter units of the inverter system 13.

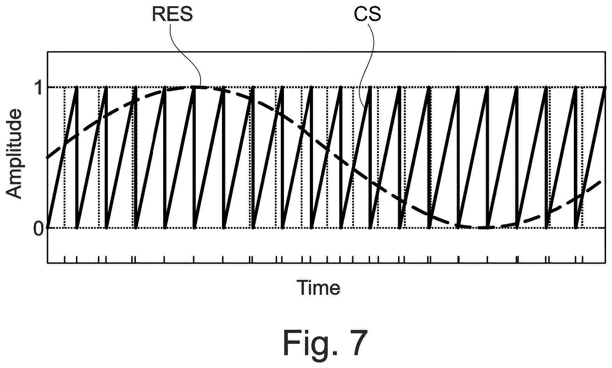

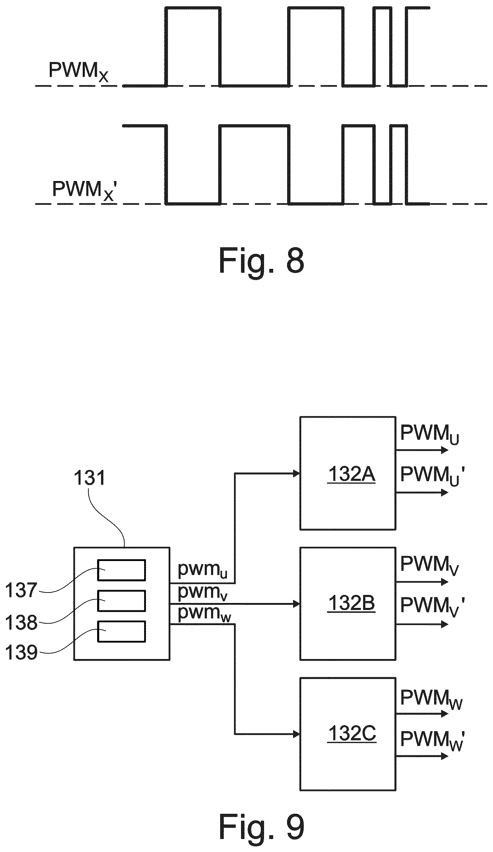

The half-bridge circuit has a series circuit including two electronic switching elements (e.g., transistors) that are connected to the DC bus 30. The electronic switching elements are operated in a clock mode, as explained in more detail below in connection with FIGs. 7 and 8, which provides a signal (e.g., signals for the gate drives) in the manner of a PWM signal, for example. The corresponding phase U, V, W of the three-phase AC voltage is then available at a respective center tap of the half-bridge circuits. Filtering is carried out by the inductance of the windings 12A-12C, with the result that an appropriate AC current is established for each phase U, V, W, which AC current may be virtually sinusoidal if the inverter units are suitably controlled.

The inverter system 13 comprises a first inverter 134A and a second inverter 134B. the first inverter 134A comprises a first set of inverter units, in this example three, i.e., one for each phase U, V, W. The second inverter 134B comprises a second set of inverter units, in this example three, i.e., one for each phase U, V, W. The windings 12A-12C are divided in two winding systems WS1, WS2. Thereof, a first winding system WS1 is electrically connected to the first inverter 134A and is not electrically connected to the second inverter 134B. Accordingly, the second winding system WS2 is electrically connected to the second inverter 134B and is not electrically connected to the first inverter 134A. The first inverter 134A can operate the first winding system WS1 independently of the second inverter 134B and second winding system WS2 (and vice versa). If one of the inverters 134A, 134B or one of the winding systems WS1, WS2 fails, the other can still be operated to drive the rotor 20.

The inverter system 13 further comprises a control unit 131. The control unit 131 controls the inverters 134A, 134B.

FIG. 2 shows a schematic exploded illustration of the stator 21 of the electric machine 2. The stator 21 has the body 10 in which the stator teeth 11 may be joined together with the annular body 10 by a mechanical connection and may thus be fixed thereon, in particular, mechanically fixed thereon. Alternatively, the stator teeth 11 may be formed in one piece with the body 10.

The stator teeth 11 are fitted with respective winding portions 122 of the windings 12A-12C. The stator winding has a plurality of windings 12A-12C, (e.g., exactly three windings). A respective one of the windings 12A-12C may be arranged at least on one of the stator teeth 11. In the present case, each winding 12A-12C extends over a plurality of stator teeth 11, (e.g., specifically two opposite stator teeth). For this purpose, each winding 12A-12C may have at least one winding portion 122 or a plurality of winding portions 122 (e.g., two winding portions). Each winding portion 122 surrounds (e.g., exactly) one stator tooth 11. In this example, each winding portion 122 forms a coil. For example, each winding 12A-12C comprises at least one coil or more than one coil. In the present example, each winding 12A-12C comprises two coils.

Each winding 12A-12C has a respective first electrical conductor 120, which at each winding portion 122 is arranged in a plurality of turns circumferentially around the respective stator tooth 11. Between the winding portions 122, the first electrical conductor 120 includes one or more corresponding connecting portions via which the portions of the first electrical conductor 120 at the winding portions 122 are electrically connected to each other.

Each winding 12A-12C further has a respective second electrical conductor 121 that likewise at each winding portion 122 is arranged in a plurality of turns circumferentially around the respective stator tooth 11. Between the winding portions 122, the second electrical conductor 121 includes one or more corresponding connecting portions via which the portions of the second electrical conductor 121 at the winding portions 122 are electrically connected to each other.

The first electrical conductors 120 and the second electrical conductors 121 each have end portions to which they are connected in a manner described in more detail below. Between the respective end portions (and, in this example, over their entire lengths), the first electrical conductors 120 and the second electrical conductors 121 are electrically insulated from each other. The windings 12A-12C are connected in the electric machine 2 such that the three-phase connection to the inverter system 13 is present.

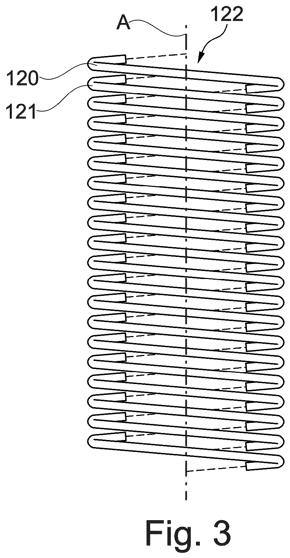

FIG. 3 shows a schematic illustration of a winding portion 122 of one of the windings 12A-12C. The first electrical conductor 120 in this case is wound around the stator tooth 11, which is not illustrated in FIG. 3. The winding on the stator tooth 11 extends here around and along a winding axis A. In the present case, the winding portion 122 is configured in the form of an elongate coil along the winding axis A.

Furthermore, the winding portion 122 of the winding 12A-12C includes the respective second electrical conductor 121 that is electrically insulated from the first electrical conductor 120. The second electrical conductor 121 also has a plurality of turns arranged circumferentially around the same stator tooth 11, so that the winding on the stator tooth 11 extends around and along the winding axis A. The respective turns of the first and second electrical conductors 120, 121 are arranged in a bifilar manner. In other words, one turn of the first electrical conductor 120 is arranged between two adjacent turns of the second electrical conductor 121 (and vice versa) along the winding axis A of the winding portion 122 (with the exception of the outermost two turns). This has the advantage that, in the event of an inter-turn short circuit between two adjacently arranged turns, the inter-turn short circuit occurs between the first electrical conductor 120 and the second electrical conductor 121. An inter-turn short circuit thus does not occur inside a winding of the same electrical conductor. This makes it possible to prevent large currents in the case of an inter-turn short circuit and therefore large thermal and electrical stresses.

Notably, the coils formed by the respective winding portions 122 may be elongate (e.g., in a direction parallel to the rotor 20 rotational axis), as shown in FIG. 2. Here, the winding axis A may be defined to be at a position inside the coil, e.g., in the center of the coil. More complicated coil shapes are also possible, such as bent along the longitudinal axis, particular for alternative machine topologies such as a transverse flux machine or the like.

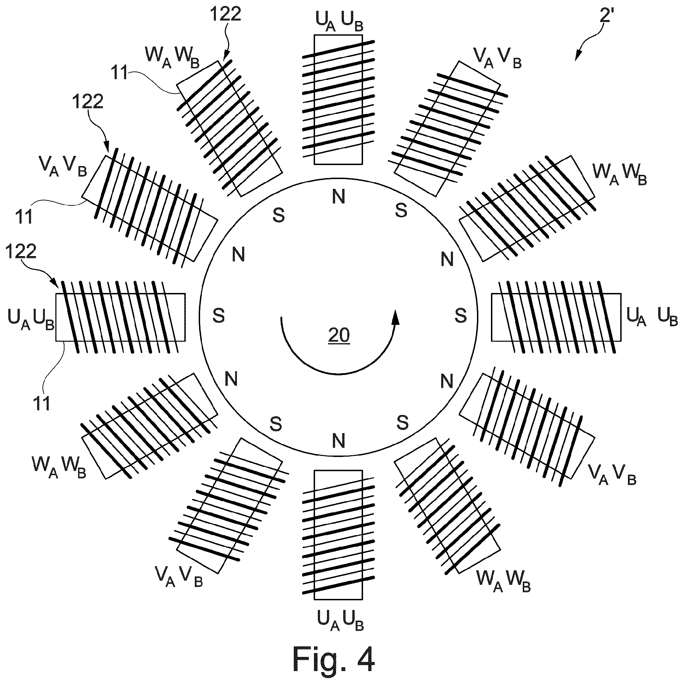

FIG. 4 shows a schematic illustration of an electric machine 2' in the form of a synchronous machine that, in contrast to the electric machine 2 according to FIGS. 1 and 2, now has a twelve-pole rather than a six-pole design. The corresponding stator therefore has twelve stator teeth 11. These are arranged equidistantly in the circumferential direction in the present case. The rotor 20 is again arranged in a through-opening formed by the stator, which rotor likewise has a twelve-pole design in this configuration and therefore provides six north poles N and six south poles S arranged in alternation in the circumferential direction. Here too, the magnetic flux provided by the rotor 20 is provided by permanent magnets arranged, e.g., in the region of the outer circumference of the rotor 20. The numbers of poles are provided by way of example and larger or smaller numbers are also possible.

Each stator tooth 11 of the stator teeth 11 is also equipped here with a winding portion 122 of one of the three windings 12A-12C. Each winding of the three windings 12A-12C again has a respective first electrical conductor and a respective second electrical conductor (illustrated by different line thicknesses in FIG. 4 purely for the purposes of illustration) that are wound onto the respective stator teeth 11 in a bifilar manner. This electric machine 2' is likewise designed to be supplied with a three-phase AC voltage, wherein each of the phases is again denoted using U, V, W.

The electric machines 2, 2' described with reference to FIGS. 1-4 are inner-runner radial flux machines. Notably, the principles described herein can also be applied to outer-runner radial flux machines as well as to a transverse flux machine and to an axial flux machine.

FIG. 5 shows an electrical interconnection of the windings 12A-12C and the inverter units 130A-130F of the inverter system 13 of the electric machine 2 according to FIG. 1.

The first electrical conductors 120 (e.g., three first electrical conductors) of the windings 12A-12C form the first winding system WS1 and the second electrical conductors 121 (e.g., three second electrical conductors) of the windings 12A-12C form the second winding system WS2. The first winding system WS1 is connected to three inverter units 130A-130C. These three inverter units 130A-130C form the first three-phase inverter 134A. Each first electrical conductor 120 is connected with an end portion WA2, VA2, UA2 thereof to one of the inverter units 130A-130C. The respective other end portions WA1, VA1, UA1 of the first electrical conductors 120 are electrically connected to each other at a first star point 123.

The second winding system WS2 is connected to further three inverter units 130D-130F. These further three inverter units 130D-130F form the second three-phase inverter 134B. Each second electrical conductor 121 is connected with an end portion WB1, VB1, UB1 to one of the inverter units 130D-130F. The respective other end portions WB2, VB2, UB2 of the second electrical conductors 121 are electrically connected to each other at a second star point 124.

The inverter system 13 thus includes six inverter units 130A-130F, two for each of the three phases U, V, W, and of these two inverter units, one each for the first winding system WS1 and one for the second winding system WS2. As already described, each inverter unit 130A-130D has a half-bridge circuit. An optional capacitor is used as a low-pass filter in each case.

The (e.g., same) DC bus 30 voltage (designated by HV+ and HV-) is applied to the inverter units 130A-130F of both inverters 134A, 134B of the inverter system 13. For example, the DC voltage is 25 V or more, 100 V or more, or in a range of 800 to 3000 V.

Furthermore, all six winding portions 122 for the six stator teeth 11 are shown, wherein each winding of the first and second electrical conductors 120, 121 is illustrated only schematically.

First, the winding 12A for a first phase W will be considered. This winding 12A includes a first electrical conductor 120 and a second electrical conductor 121. Both electrical conductors 120, 121 extend over winding portions 122 on the same (e.g., one or more, in this example two) stator teeth 11 but are insulated from one another. Both electrical conductors 120, 121 have the aforementioned two end portions WA1, WA2, WB1, WB2. Here, both electrical conductors 120, 121 are free of junctions between their end portions WA1, WA2, WB1, WB2. The electrical conductors 120, 121 each establish an electrical connection between the respective two end portions WA1, WA2, WB1, WB2. The winding portions 122 of the winding 12A lie between the end portions WA1, WA2, WB1, WB2 of the electrical conductors 120, 121.

One end portion WA2 of the first electrical conductor 120 is electrically connected to a first inverter unit 130A of the inverter system 13, and the other end portion WA1 of the first electrical conductor 120 is electrically connected to the first star point 123. One end portion WB1 of the second electrical conductor 121 is electrically connected to a fourth inverter unit 130D of the inverter system 13, and the other end portion WB2 of the second electrical conductor 121 is electrically connected to the second star point 124.

The end portions of the first electrical conductor 120 of the winding 12B for a second phase V are denoted using VA1 and VA2. One end portion VA2 of the first electrical conductor 120 is electrically connected to the inverter system 13, specifically, to a second inverter unit 130B thereof, and the other end portion VA1 of the first electrical conductor 120 is electrically connected to the first star point 123.

The end portions of the second electrical conductor 121 of the winding 12B for the second phase V are correspondingly denoted using VB1 and VB2. One end portion VB1 of the second electrical conductor 121 is electrically connected to the inverter system 13, specifically, to a fifth inverter unit 130E thereof, and the other end portion VB2 of the second electrical conductor 121 is electrically connected to the second star point 124.

The end portions of the first electrical conductor 120 of the winding 12C for a third phase U are denoted using UA1 and UA2. One end portion UA2 of the first electrical conductor 120 is electrically connected to the inverter system 13, specifically to a third inverter unit 130C thereof, and the other end portion UA1 of the first electrical conductor 120 is electrically connected to the first star point 123.

The end portions of the second electrical conductor 121 of the winding 12C for the third phase U are correspondingly denoted using UB1 and UB2. One end portion UB1 of the second electrical conductor 121 is electrically connected to the inverter system 13, specifically, to a sixth inverter unit 130F thereof, and the other end portion UB2 of the second electrical conductor 121 is electrically connected to the second star point 124.

The arrangement 1 comprises the first winding system WS1 and the second winding system WS2. The winding systems WS1, WS2 are electrically disconnected (and isolated) from one another. However, both winding systems WS1, WS2 may be powered by the same DC bus 30. As described above, the two winding systems WS1, WS2 have electrical conductors 120, 121 that form a plurality of coils in a bifilar arrangement. At least one (first) electrical conductor 120 (in the present example three first electrical conductors 120) of the first winding system WS1 and at least one (second) electrical conductor 121 (in the present example three second electrical conductors 121) of the second winding system WS2 are at least partially wound around a common winding axis A that alternate between winding systems in a direction of the winding axis A (e.g., as shown in Fig. 4). In the direction of the winding axis A, each turn of the first electrical conductor 120 within the coil is arranged (directly) between two turns of the second electrical conductor 121 (isolated from one another). Correspondingly, in the direction of the winding axis A, each turn of the second electrical conductor 121 within the coil is arranged (directly) between two turns of the first electrical conductor 120 (isolated from one another). Denoting the first electrical conductor 120 as "A" and the second electrical conductor 121 as "B", the arrangement along the winding axis A may be A-B-A-B (and so forth).

The arrangement 1 further comprises the inverter system 13 which includes the first inverter 134A for the first winding system WS1 and the second inverter 134B for the second winding system WS2. The first inverter 134A is configured for supplying the first winding system WS1 with a multi-phase (here: three-phase) current. The second inverter 134B is configured for supplying the second winding system WS2 with a multi-phase (here: three-phase) current.

The control unit 131 of the inverter system 13 may comprise several blocks or components that may be embodied as software and/or hardware and that may be located adjacent or distant to one another.

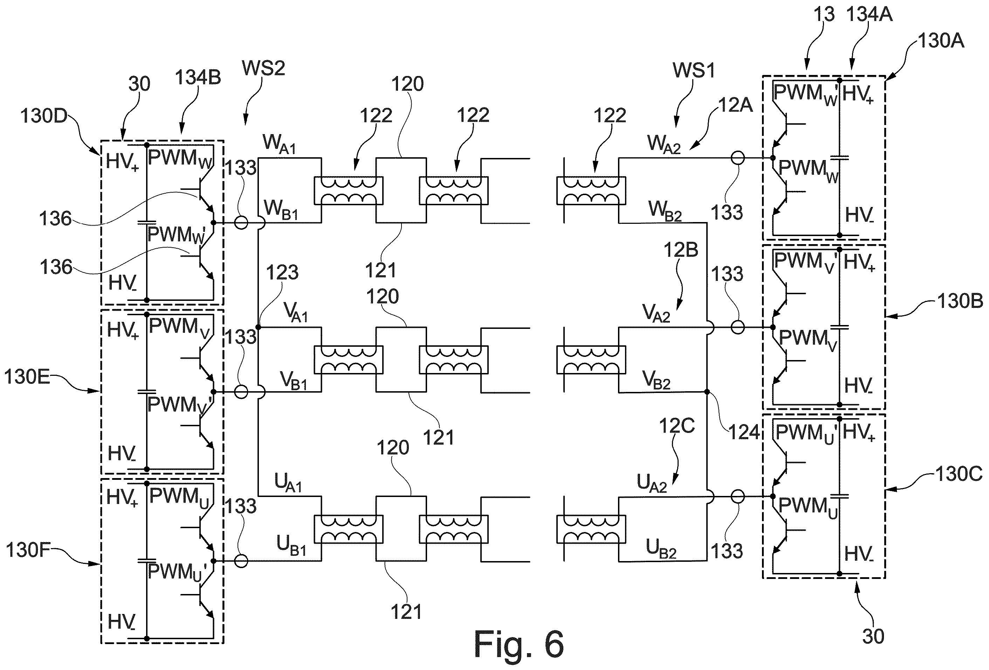

FIG. 6 shows substantially the same circuitry as FIG. 5, wherein more winding portions 122 are illustrated. It can be seen that the windings 12A-12C may have a smaller or larger number of winding portions 122 depending on the application, e.g., in total six (cf. in particular FIGS. 2 and 5), twelve (cf. in particular FIG. 4), or 18, to name just some examples.

While the windings 12A-12C are arranged between the inverter units 130A-130F according to FIGS. 5 and 6, this arrangement is only exemplary. Indeed, the inverters 134A, 134B may be electrically connected to the winding systems WS1, WS2 from the opposite ends, as shown in FIGs. 5 and 6, or from the same ends. In the latter case, the star points 123, 124 would be one the same side of the windings 12A-12C.

Furthermore, it may be seen that in FIGS. 5 and 6 the end portions, connected to the inverter units 130A-130F, of the first and second conductors 120, 121 of each individual one of the windings 12A-12C face away from one another with respect to the common winding portions 122.

To create the alternating three-phase voltage, currents introduced into the electrical conductors 120, 121 are controlled by switching the transistors (or other types of switches 136) of the inverter units 130A-130F. The transistors are controlled by signals, in the present case by pulse width modulated signals, which may also be referred to as PWM signals for short. The PWM signals alternate between two discrete values, e.g., "on" and "off", which open and close the corresponding transistor (or other type of switch 136), respectively.

FIG. 8 shows an example of such PWM signals, while FIG. 7 illustrates the creation of such PWM signals.

Referring to FIG. 7, two time-varying signals are shown, a carrier signal CS and a reference signal RES. The carrier signal CS determines the switching frequency fsw at which the switches 136 of the inverters 134A, 134B are switched. Together with the reference signal, the duty cycle per switching period (repeated at the switching frequency) is defined.

Pulse-width modulation (PWM)can be used to generate a fundamental oscillation of the output voltage with variable amplitude, phase and frequency without having to change the DC link voltage. Different methods exist to modulate the output voltage by switching the power electronic switches 136 of the half bridges on and off.

Here, a simple form of a modulation applying a comparison of a sawtooth (or triangle) carrier signal CS with the period of 1/fsw, with a variable sine wave reference signal RES creates the PWM waveforms, i.e., the time-varying electrical potential connections per phase and the resulting line-to-line voltages. In the three-phase converters, the second and the third phases use reference signals RES with the same fundamental frequency fel, i.e., the electrical frequency at which the electrical machine 2, 2' is driven electromagnetically, which are phase-shifted by 120° and 240°, respectively.

For time periods when the sawtooth (or, e.g., triangle) carrier signal CS is greater than the reference signal RES, the half-bridge is switched to the low-voltage potential (or vice versa). If the carrier signal CS is lower than the sine reference signal RES, the half-bridge is switched to the high-voltage potential (or vice versa). Thus, operating the electric machine 2, 2' comprises comparing the carrier signal CS with the reference signal RES which has the fundamental frequency fel.

The ratio of the amplitude of the sine wave reference signal RES and the peak value of the sawtooth (or triangle) carrier signal CS is called the modulation index M.

Referring to FIG. 8, X stands for the respective phase U, V, W. The PWM signals for the individual phases U, V, W are, e.g., the same, only shifted in time as described above.

Furthermore, an inverted PWMX' signal is provided for each PWMX signal, which assumes the corresponding opposite discrete value in relation to the PWMX signal over time. The PWMX' signal corresponds to the inverted PWMX signal when the inverters of the two systems are supplied from the opposite. In the case of the inverters of the two systems are on the same side (i.e., the star points are also on the same side), the PWM signal of the phase does not need to be inverted.

In the first case with the supply from the opposite sides, as illustrated, e.g., with reference to FIGS. 5 and 6, for each winding 12A-12C, the reverse PWM signal PWMW', PWMV', PWMU' is applied to the respective transistor of the inverter unit 130A, 130B, 130C of the first electrical conductor 120 connected to the positive electric potential HV+ of the DC voltage. By contrast, the PWM signal PWMW, PWMV, PWMU is applied to the transistor of the inverter unit 130A, 130B, 130C of the first electrical conductor 120 connected to the negative electric potential HV- of the DC voltage.

For the second electrical conductors 121, the PWM signals are applied in reverse. The PWM signal PWMW, PWMV, PWMU is applied to the transistor of the inverter unit 130D, 130E, 130F of the second electrical conductor 121 connected to the positive electric potential HV+ of the DC voltage. By contrast, the reverse PWM signal PWMW', PWMV', PWMU' is applied to the transistor of the inverter unit 130D, 130E, 130F of the second electrical conductor 121 connected to the negative electric potential HV- of the DC voltage.

It may therefore be seen that the same PWM signals may be applied to the inverter units 130A-130C of the first electrical conductor 120 as to the inverter units 130D-130F of the second electrical conductor 121.

FIG. 9 illustrates a possible generation of the PWM signals PWMX and the reverse PWM signals PWMX'. The control unit 131 of the inverter system 13 generates signals for the three phases U, V, W, which are designated here as pwmu, pwmv, pwmw.

These are each provided to a power electronics driver 132A-132C, which generate the respective PWM signals and reverse PWM signals for the corresponding phase U, V, W based on them. The power electronics drivers 132A-132C are connected (e.g., electrically) to the inverter units 130A-130F of the respective phase U, V, W.

Returning to FIG. 5, the arrangement 1 comprises a plurality of sensors 133, each of the plurality of sensors 133 being configured for sensing at least one electrical parameter. At least one sensor 133 is arranged to sense the at least one electrical parameter at (and of) the first winding system WS1. At least one sensor 133 is arranged to sense the at least one electrical parameter at (and of) the second winding system WS2. In the present example, a plurality of sensors 133 is arranged to sense a respective electrical parameter at (and of) the first winding system WS1 and a plurality of sensors 133 is arranged to sense a respective electrical parameter at (and of) the second winding system WS2. Here, the electrical parameters are electrical currents.

Each one sensor 133 is arranged to sense the strength of the current through each phase U, V, W of each of the winding systems WS1, WS2, so, in the present example, six sensors 133 are provided (although other numbers are also possible). The sensors 133 generate sensor signals that are indicative of the respective electrical parameter, in the present example the phase current through the respective conductor.

In case of an insulation fault such as an inter-turn short circuit, the resistance between the winding systems WS1, WS2 changes. To detect an insulation fault based on the sensor signals, the control unit 131 is further configured as described further below.

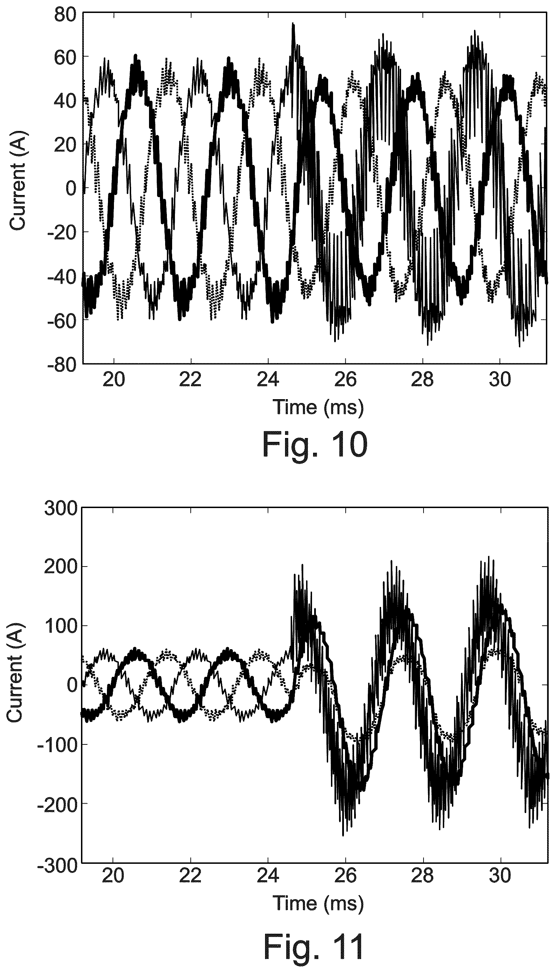

FIG. 10 shows the phase currents of the three phases U, V, W versus time. The first approx. 24 ms there is no fault. In this moment, a high resistance short circuit of 10 Ohms occurs. The diagram shows the three-phase current imbalance created by this turn-to-turn fault.

FIG. 11 shows the same diagram as FIG. 10, however, with a fault resistance of several orders of magnitude lower, namely, of 1 milliohm.

It can be seen that a sudden increase of the current as shown in FIG. 11, can be interpreted as a sign of an insulation fault, however, a low-resistance fault such as shown in FIG. 10 may be very difficult to detect when merely considering the amplitudes of the phase currents, particularly when the measured phase currents are subject to noise. At an early stage of a fault which corresponds to an increment of the fault resistance, detecting the fault becomes more and more challenging.

When a fault (e.g., an inter-turn short circuit) is detected, the control unit 131 optionally switches off all PWM signals (e.g., to zero) and/or applies other countermeasures.

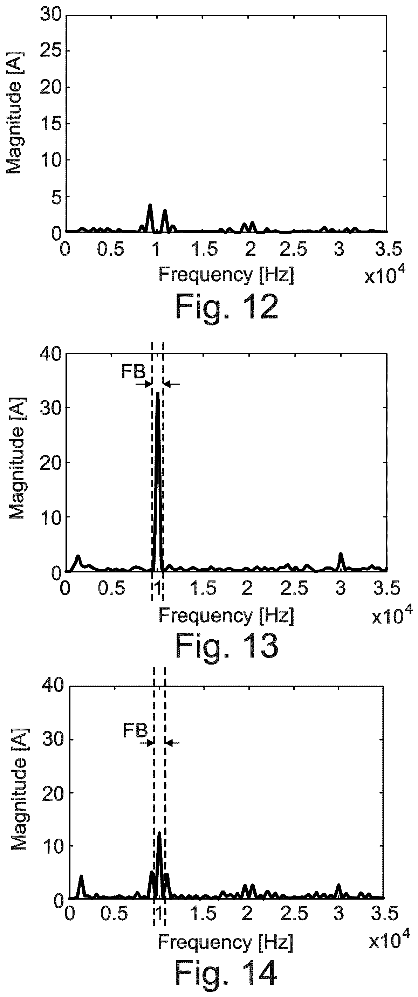

FIG. 12 shows one of the phase current harmonic spectra of a sine PWM driven inverter supply in a healthy state without short circuit. The fundamental component is excluded. In this example, the switching frequency fsw is 10 kHz. The switching frequency fsw may be, such as in the present example, constant.

In the line-to-line voltages of a three-phase system the harmonics of the fundamental wave mode which can be divided by 3 are eliminated. Furthermore, the integer multiples of the switching frequency components are eliminated because they are in phase in all three lines. The harmonics due to the modulation occurs at the frequencies n * fsw +/-m * fel, where m and n are natural numbers and m + n is an odd number. The dominant harmonic amplitudes occur at the following frequencies: $f 1 , 2 = fsw + / - 2 * fel$ and $f 3 , 4 = 2 * fsw + / - fel .$ as demonstrated in the example in FIG. 12.

Depending on the magnitude of the modulation index M, the relative significance of these frequencies changes. At low M, the modes around double the switching frequencies are more pronounced. At high M close to 1, the lower-frequency modes at a distance of twice the fundamental frequency around the switching frequency are higher than the previously mentioned higher-frequency modes. Notably, fsw and 2 * fsw are not excited in the spectra when the electric machine 2, 2' is healthy.

In the case of an inter-turn short circuit in the bifilar electric machine 2, 2', the three-phase symmetry of the healthy state is broken. There are harmonic components at the switching frequency fsw and at its odd integer multiples which do not occur in healthy conditions. In the frequency spectrum, this mode has a significant amplitude and is found in the above-mentioned range f = fsw +/- 2 * fel. This enables a detection of faults by considering (e.g., band-pass filtering) a narrow frequency band around the switching frequency fsw.

FIG. 13 illustrates the phase current harmonic spectrum of a fault with a short circuit. The described signal is clearly visible.

Accordingly, the control unit 131 is configured to operate the electric machine 2, 2' with pulse-width modulation based on the carrier signal CS having the frequency fsw; measure at least one phase current of at least one phase U, V, W of the bifilar electric machine 2, 2' during the operation of the electric machine 2, 2'; analyze a frequency band FB (see FIG. 13) of the at least one phase current of the at least one phase U, V, W around the switching frequency fsw or around an integer multiple of the switching frequency fsw to obtain a value; and compare the value with a threshold to detect a fault if the value exceeds the threshold.

For example, the value characterizes the signal energy within the frequency band FB, which is an integral of the spectral density over the interval. Here, value is the spectral energy within the frequency band FB. Alternatively, a magnitude within the frequency band FB may be used, e.g., the maximum magnitude within the frequency band FB or the signal magnitude at the center frequency of the pass band.

As can be seen in FIG. 13, the frequency band FB is centered at the switching frequency fsw. Alternatively, or in addition, the frequency band or an additional frequency band may be centered at an integer multiple the switching frequency fsw, e.g., at three times the switching frequency fsw where another signature of the fault can be seen, compare FIG. 13 with FIG. 12.

The width of the frequency band FB may be equal to or smaller than four times the fundamental frequency fel, in particular equal to or smaller than two times the fundamental frequency fel. To give an example, the width of the frequency band FB may be 100 Hz or 200 Hz or another frequency in between, or even smaller than 100 Hz.

To give further examples, the fundamental frequency may be in the range of fel = [50,1000] Hz. The switching frequency may be in the range of fsw = [10, 20] kHz. Thus, in the present example the switching frequency fsw is at least one order of magnitude higher than the fundamental frequency fel of the reference signal RES.

The switching frequency fsw may be fixed. On the other hand, the threshold may be variable. For example, the threshold and/or the pass-band width is/are defined based on the rotational speed of the rotor 20.

Turning now to FIG. 14 it can be seen that, even for the shown example of an emerging fault that has a high resistance of 10 Ohms (for comparison, the phase resistance of an investigated example electrical machine is 40 mOhms), there is a clear fault indication in the detection frequency band FB. Besides the switching frequency component, the odd switching harmonics components can also be used for the detection, as described, alternatively or in addition.

To further improve the precision of the measurement, the spectra of corresponding phases of the two winding systems WS1, WS2 can be added (or the phase current signals are added).

In order to extract the frequency band, a frequency analysis of the phase current signals (measured, e.g., by one or more of the sensors 133) may be performed, e.g., using a Fourier analysis. Alternatively or in addition, the control unit 131 may comprise a digital or analogue bandpass filter 139. Analyzing the frequency band FB may comprise applying the bandpass filter 139 to the measured at least one phase current (cf. FIG. 9). The bandpass filter 139 may be fixed.

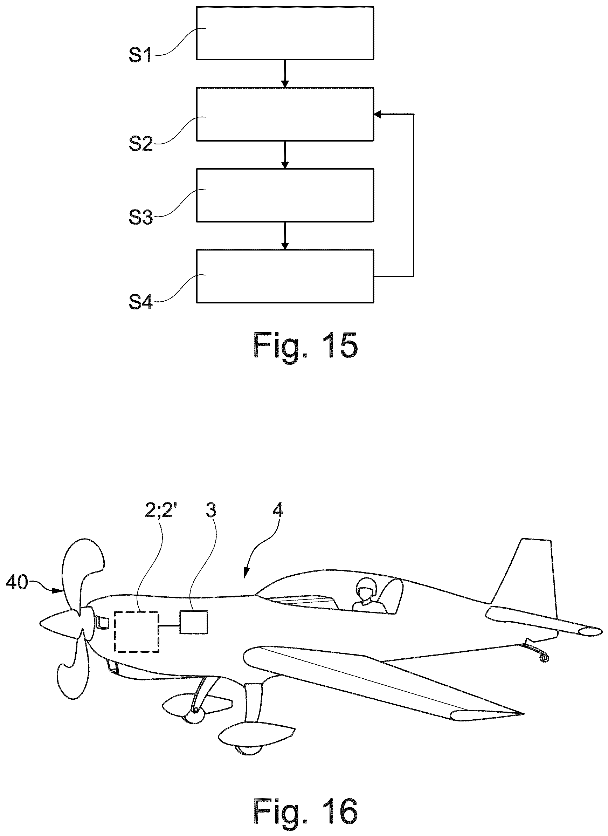

FIG. 15 shows a method for detecting a fault in a bifilar electric machine 2, 2'. The method may be performed by the control unit 131 and comprises:
Step S1: Operating the electric machine 2, 2' with pulse-width modulation based on a carrier signal CS having a switching frequency fsw.
Step S2: Measuring at least one phase current of at least one phase U, V, W of the electric machine 2, 2' during the operation of the electric machine 2, 2'.
Step S3: Analyzing a frequency band FB of the at least one phase current of the at least one phase U, V, W around the switching frequency fsw or around an integer multiple of the switching frequency fsw to obtain a value.
Step S4: Comparing the value with a threshold to detect a fault if the value exceeds the threshold. If the value exceeds the threshold (e.g., 10 A to give just an example), the method concludes that there is a fault. The method may also determine the severity of the fault, e.g., estimate the resistance of the short circuit based on the value.

The method may comprise any of the further details or steps as described above with reference to the arrangement 1.

By performing the described analysis on each phase U, V, W, the faulty phase can be identified.

As illustrated in FIG. 9, the control unit 131 comprises a computer-readable storage medium 138 and at least one processor 137. The computer-readable storage medium 138 comprises instructions that, when executed by at least one processor 137 of the control unit 131 of the bifilar electric machine 2, 2', cause the control unit 131 to perform the method of FIG. 15.

FIG. 16 shows an aircraft 4 in the form of an electrically driven airplane. The aircraft 4 includes a propeller 40 which is driven by the above-described electric machine 2 according to FIG. 2 (alternatively by the electric machine 2' according to FIG. 4).

The aircraft 4 furthermore includes the energy source 3 in the form of an electric battery. The electric machine 2 is supplied with energy by the energy source 3, wherein the energy source 3 is electrically connected to the inverter system 13.

Notably, the bifilar system does not have to be composed of three-phase winding subsystems. Any multi-phase configuration enabling potential differences between the turns of the two winding sets in the built-in test are conceivable.

Further, instead of the illustrated star point 123, 124 connections, full H-bridge inverters may be used. Then, each electrical conductor 120, 121 is connected to one inverter unit with one end and to another inverter unit at its other end. The inverter units may be configured as described above. For such a system a mode at the fundamental frequency will always be present due to the fact that there is no cancellation by incoming waves of other systems. However, the magnitude of the mode will change in case of a connection between the two systems and this change might also be used for fault detection as described. Furthermore, an artificial star-point can be created by summing measurements of all phases computationally. Depending on the number of phases a different phase shift in this summation may be considered to obtain the cancellation in the healthy state.

The disclosure is not limited to the embodiments described above, and various modifications and improvements may be made without departing from the concepts described here. Any of the features may be used separately or in combination with any other features, unless they are mutually exclusive, and the disclosure extends to and includes all combinations and sub-combinations of one or more features that are described herein.

It is to be understood that the elements and features recited in the appended claims may be combined in different ways to produce new claims that likewise fall within the scope of the present disclosure. Thus, whereas the dependent claims appended below depend on only a single independent or dependent claim, it is to be understood that these dependent claims may, alternatively, be made to depend in the alternative from any preceding or following claim, whether independent or dependent, and that such new combinations are to be understood as forming a part of the present specification.

While the present disclosure has been described above by reference to various embodiments, it may be understood that many changes and modifications may be made to the described embodiments. It is therefore intended that the foregoing description be regarded as illustrative rather than limiting, and that it be understood that all equivalents and/or combinations of embodiments are intended to be included in this description.

### LIST OF REFERENCE SIGNS

- 1: arrangement
- 10: body
- 11: stator tooth
- 12A-12C: winding
- 120: first electrical conductor
- 121: second electrical conductor
- 122: winding portion
- 123: first star point
- 124: second star point
- 13: inverter system
- 130A-130F: inverter unit
- 131: control unit
- 132A-132C: power electronics driver
- 133: sensor
- 134A, 134B: inverter
- 136: switch
- 137: processor
- 138: computer-readable storage medium
- 139: bandpass filter
- 2, 2': electric machine
- 20: rotor
- 21: stator
- 3: energy source
- 30: DC bus
- 4: aircraft
- 40: propeller
- A: winding axis
- CS: carrier signal
- FB: frequency band
- L: air gap
- N: north pole
- RES: reference signal
- S: south pole
- U, V, W: phase
- WS1, WS2: winding system

## Claims

1. A method for detecting a fault in a bifilar electric machine (2, 2'), comprising:
- operating (S1) the electric machine (2, 2') with a pulse-width modulated voltage supply using a switching frequency fsw;
- measuring (S2) at least one phase current of at least one phase (U, V, W) of the electric machine (2, 2') during the operation of the electric machine (2, 2');
- analyzing (S3) a frequency band (FB) of the at least one phase current of the at least one phase (U, V, W) around the switching frequency fsw and/or around an integer multiple of the switching frequency fsw to obtain a value; and
- comparing (S4) the value with a threshold to detect a fault if the value exceeds the threshold.

2. The method of claim 1, wherein the value is the spectral energy within the frequency band (FB) or the maximum magnitude within the frequency band (FB).

3. The method of claim 1 or 2, wherein the frequency band (FB) is centered at the switching frequency fsw or an integer multiple thereof.

4. The method of claim 3, wherein operating the electric machine (2, 2') comprises comparing a carrier signal (CS) having the switching frequency fsw with a reference signal (RES) having a fundamental frequency fel.

5. The method of claim 4, wherein the width of the frequency band (FB) is equal to or smaller than four times the fundamental frequency fel, in particular equal to or smaller than two times the fundamental frequency fel.

6. The method of claim 4 or 5, wherein the carrier signal (CS) is a sawtooth signal or a triangle signal and the reference signal (RES) is a sine wave.

7. The method of any of claims 4 to 6, wherein the switching frequency fsw is at least one order of magnitude higher than the fundamental frequency fel of the reference signal (RES).

8. The method of any of the preceding claims, wherein the threshold and/or the frequency band (FB) width is defined based on an operating speed of the electric machine (2, 2').

9. The method of any of the preceding claims, wherein:
- the electric machine (2, 2') comprises a first winding system (WS1) and a second winding system (WS2), wherein at least one electrical conductor (120) of the first winding system (WS1) and at least one electrical conductor (121) of the second winding system (WS2) are at least partially wound around a common winding axis (A), wherein turns of the electrical conductors (120, 121) alternate in a direction of the winding axis (A);
- measuring (S2) the at least one phase current comprises measuring a phase current of at least one phase (U, V, W) of the first winding system (WS1) and measuring a phase current of at least one phase (U, V, W) of the second winding system (WS2) during the operation of the electric machine (2, 2') and adding the phase currents, before the analyzing of the frequency band (FB) thereof.

10. A computer-readable storage medium (138) comprising instructions that, when executed by at least one processor (137) of a control unit (131) of a bifilar electric machine (2, 2'), cause the control unit (131) to perform the method of any of the preceding claims.

11. An arrangement (1), comprising:
- an electric machine (2, 2') with a first winding system (WS1) and a second winding system (WS2), wherein at least one electrical conductor (120) of the first winding system (WS1) and at least one electrical conductor (121) of the second winding system (WS2) are at least partially wound around a common winding axis (A), wherein turns of the electrical conductors (120, 121) alternate in a direction of the winding axis (A);
- a first inverter (134A) for supplying the first winding system (WS1) with a multi-phase current;
- a second inverter (134B) for supplying the second winding system (WS2) with a multi-phase current; and
- a control unit (131) configured to:
∘ operate the electric machine (2, 2') with pulse-width modulation with a switching frequency fsw;
∘ measure at least one phase current of at least one phase (U, V, W) of the electric machine (2, 2') during the operation of the electric machine (2, 2');
∘ analyze a frequency band (FB) of the at least one phase current of the at least one phase (U, V, W) around the switching frequency fsw and/or around an integer multiple of the switching frequency fsw to obtain a value; and
∘ compare the value with a threshold to detect a fault if the value exceeds the threshold.

12. The arrangement (1) of claim 11, wherein the control unit (131) comprises a digital or analogue bandpass filter (139), wherein analyzing the frequency band (FB) comprises applying the bandpass filter (139) to the measured at least one phase current.

13. The arrangement (1) of claim 11 or 12, wherein the first winding system (WS1) comprises three phases connected to one another with one respective end at a common first star point (123) and to an inverter unit (130A-130C) of the first inverter (134A) with the respective other end, and wherein the second winding system (WS2) comprises three phases connected to one another with one respective end at a common second star point (124) and to an inverter unit (130D-130E) of the second inverter (134B) with the respective other end.

14. The arrangement (1) of any of claims 11 to 13, wherein the electric machine (2, 2') comprises a stator (21) with the winding systems (WS1, WS2) and a rotor (20) rotatably mounted at the stator (21).

15. An aircraft (4) comprising the arrangement (1) of any of claims 11 to 14.
